# EUROPÄISCHE PATENTSCHRIFT

(11) **EP 1 052 778 B1**
(45) Veröffentlichungstag und Bekanntmachung des Hinweises auf die Patenterteilung: **02.01.2008**
(21) Anmeldenummer: 00109445.7
(22) Anmeldetag: 03.05.2000
(51) Int. Cl.: H03K 19/18

(54) **Verfahren und Vorrichtung zur logischen Verknüpfung von Signalen auf magnetischer Basis**
Method and device for logically combining signals using magnetic means
Méthode et dispositif pour combiner logiquement des signaux à l'aide de moyens magnétiques

(30) Priorität: 12.05.1999 DE 19922129
(43) Veröffentlichungstag der Anmeldung: 15.11.2000
(73) Patentinhaber: SIEMENS AKTIENGESELLSCHAFT, 80333 München (DE)
(72) Erfinder: Munz, Dieter, Dipl.-Ing. (FH), 91315 Höchstadt (DE); Günther, Harald, Dipl.-Ing., 90537 Feucht (DE); Staudt, Michael, Dipl.-Ing. (FH), 90469 Nürnberg (DE)

(56) Entgegenhaltungen:
- DE-A- 19 718 420
- US-A- 4 075 671
- US-A- 5 483 162
- HASSOUN ET AL: "field programmable logic gates using gmr devices" IEEE TRANSACTIONS ON MAGNETICS, Bd. 33, Nr. 5, September 1997 (1997-09), Seiten 33073307-3309, XP002145267 new-york

## Beschreibung

Die Erfindung betrifft ein Verfahren und eine Vorrichtung zur logischen Verknüpfung von Signalen.

Zur Realisierung logischer Verknüpfungen von Signalen werden in der Regel Halbleiterbauelemente verwendet, die in Form von integrierten Schaltungen hergestellt sind. In dem vom Springer Verlag 1990 herausgegebenen Buch "Halbleiter-Schaltungstechnik" von U. Tietze und Ch. Schenk, 9. Auflage, sind eine Vielzahl derartiger Halbleiterbauelemente beschrieben. Beispielsweise können unter Verwendung von Halbleiterbauelementen UND-Verknüpfungen, ODER Verknüpfungen, Multiplexer, Demultiplexer und andere logische Verknüpfungen realisiert werden.

Weiterhin ist aus der DE-197 18 420 A1 bereits eine integrierte Datenübertragungsschaltung mit Potentialtrennung zwischen Ein- und Ausgangsschaltkreis bekannt. Diese weist ein integriertes, magnetosensitives Koppelelement auf, unter dessen Verwendung die dem Eingangsschaltkreis zugeführten binären Eingangssignale in den Ausgangsschaltkreis übertragen und an dessen Ausgang in binärer Form zur Verfügung gestellt werden. Mittels des magnetosensitiven Koppelelementes wird ein im Bereich einer Leiterschleife erzeugtes, sich in Abhängigkeit vom Eingangssignal änderndes Magnetfeld detektiert und in Form der genannten binären Signale weitergeleitet. Das magnetosensitive Koppelelement kann in Form eines Hallgenerators, eines anisotropen, magnetoresistiven Bauelementes (AMR), eines giant magnetosensitiven Bauelementes (GMR) oder eines tunnel magnetosensitiven Bauelementes (TMR) realisiert sein.

Die Realisierung von logischen Schaltungen mit GMRs ist bekannt z.B. aus IEEE TRANSACTIONS ON MAGNETICS, Bd. 33, Nr. 5, 9/1997, Seiten 3307-3309, M.M. Hassoun et al: "Field Programmable Logic Gates Using GMR Devices", worin die logische Funktion mit GMRs in einer Feldstrukturanordnung realisiert wird.

Ausgehend von diesem Stand der Technik liegt der Erfindung die Aufgabe zugrunde, ein neues Verfahren und eine neue Vorrichtung zur logischen Verknüpfung von Signalen bereitzustellen.

Diese Aufgabe wird durch ein Verfahren mit den im Anspruch 1 angegebenen Merkmalen bzw. eine Vorrichtung mit den im Anspruch 4 angegebenen Merkmalen gelöst. Vorteilhafte Ausgestaltungen und Weiterbildungen der Erfindung sind in den abhängigen Ansprüchen angegeben.

Die Vorteile der Erfindung bestehen insbesondere darin, daß sie in Anwendungsfällen, bei denen ohnehin eine galvanische Trennung unter Verwendung von magnetosensitiven Bauelementen durchgeführt wird, mit geringem Aufwand realisierbar ist. Derartige Anwendungsfälle liegen beispielsweise in der Sensortechnik vor, bei der mittels eines Sensorelementes aufgenommene Signale potentialfrei übertragen werden müssen, um eine Potentialtrennung zu erreichen. Derartige Anwendungsfälle liegen auch dann vor, wenn in einer digitalen Schaltung zur Signalspeicherung sogenannte MRAM's verwendet werden. Bei diesen Speichern handelt es sich um magnetische Speicher, die ihren Speicherzustand halten, so daß kein Refresh-Vorgang notwendig ist.

Weitere vorteilhafte Eigenschaften der Erfindung ergeben sich aus der Erläuterung von Ausführungsbeispielen anhand der Figuren. Es zeigt:
- Figur 1: ein erstes Ausführungsbeispiel für die Erfindung,
- Figur 2: ein zweites Ausführungsbeispiel für die Erfindung,
- Figur 3: ein drittes Ausführungsbeispiel für die Erfindung, und
- Figur 4: ein viertes Ausführungsbeispiel für die Erfindung.

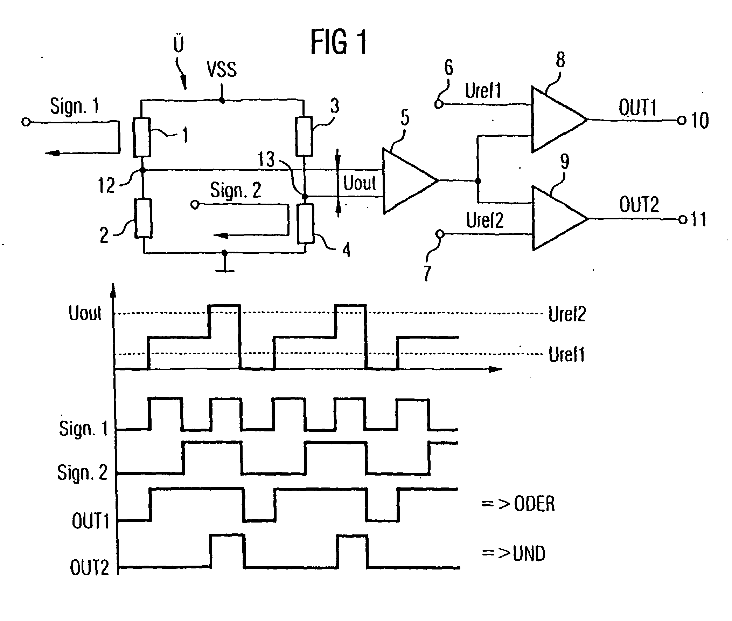

Die Figur 1 zeigt ein erstes Ausführungsbeispiel für die Erfindung. Gemäß diesem Ausführungsbeispiel sollen die beiden der gezeigten Schaltung auf getrennten Signalleitungen zugeführten Eingangssignale Sign.1 und Sign.2 im Sinne einer UND-Verknüpfung und einer ODER-Verknüpfung miteinander verknüpft werden.

Zu diesem Zweck werden die genannten Eingangssignale einem Übertrager Ü zugeführt und dort unter Verwendung jeweils einer Leiterschleife in die Nähe jeweils eines magnetosensitiven Detektors 1 bzw. 4 gebracht. Diese Detektoren sind Bestandteil einer zwischen einem Versorgungsspannungsanschluß Vₛₛ und Masse vorgesehenen Parallelschaltung mit zwei Pfaden. Im ersten Pfad sind magnetosensitive Detektoren 1 und 2 in Form einer Reihenschaltung angeordnet. Der zweite Pfad enthält magnetosensitive Detektoren 3 und 4, die ebenfalls eine Reihenschaltung bilden. Vom Verbindungspunkt 12 zwischen den magnetosensitiven Detektoren 1 und 2 führt eine Signalverbindung zu einem Eingang eines ersten Differenzverstärkers 5. Dessen anderer Eingang ist mit dem Verbindungspunkt 13 zwischen den beiden magnetosensitiven Detektoren 3 und 4 verbunden.

An den Ausgang des ersten Differenzverstärkers 5 sind zwei weitere, parallel zueinander angeordnete Differenzverstärker 8 und 9 angeschlossen. Dem weiteren Eingang des Differenzverstärkers 8 ist eine von einem Referenzspannungseingang 6 abgeleitete Referenzspannung U_{ref1} zugeführt. Der weitere Eingang des Differenzverstärkers 9 ist mit einem Eingang 7 verbunden, an welchem eine Referenzspannung U_{ref2} anliegt.

Am Ausgang 10 des Differenzverstärkers 8 ist ein Ergebnissignal OUT1 abgreifbar, welches einer ODER-Verknüpfung der beiden Eingangssignale Sign.1 und Sign.2 entspricht. Dieses Ergebnissignal OUT1 steht potentialgetrennt von den genannten Eingangssignalen zur Verfügung.

Am Ausgang 11 des Differenzverstärkers 9 ist ein Ergebniss-ignal OUT2 abgreifbar, welches einer UND-Verknüpfung der beiden Eingangssignale Sign.1 und Sign.2 entspricht. Auch dieses Ergebnissignal OUT2 steht potentialgetrennt von den genannten Eingangssignalen zur Verfügung.

Unterhalb des in der Figur 1 dargestellten Blockschaltbildes sind Signalverläufe von im Blockschaltbild auftretenden Signalen gezeigt. Bei den miteinander zu verküpfenden Signalen Sign.1 und Sign.2 handelt es sich um die zu verknüpfenden digitalen Signale. Mit Uₒᵤₜ ist die zwischen den Schaltungspunkten 12 und 13 anliegende Spannung bezeichnet, die der zwischen den beiden Eingängen des ersten Differenzverstärkers 5 vorliegenden Spannung entspricht. Bei U_{ref1} und U_{ref2} handelt es sich um die Referenzspannungen, die an den Eingängen 6 und 7 der gezeigten Schaltung anliegen. Mit OUT1 und OUT2 sind schließlich die an den Ausgängen 10 und 11 abgreifbaren Ergebnissignale bezeichnet, die der gewünschten ODER- bzw. UND-Verknüpfung der Eingangssignale Sign.1 und Sign.2 entsprechen. Diese Ergebnissignale stehen potentialgetrennt von den Eingangssignalen zur Verfügung.

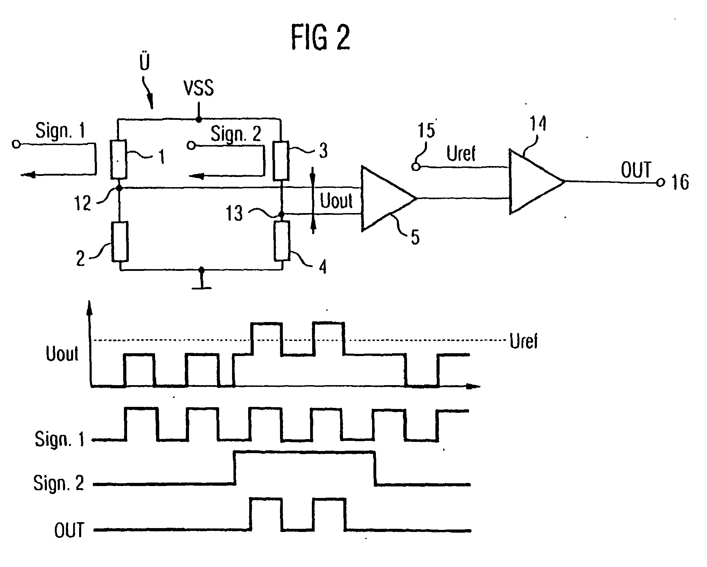

Die Figur 2 zeigt ein zweites Ausführungsbeispiel für die Erfindung. Gemäß diesem Ausführungsbeispiel sollen die beiden der gezeigten Schaltung auf getrennten Signalleitungen zugeführten Eingangssignale Sign.1 und Sign.2 derart miteinander verknüpft werden, daß mittels des Signals Sign.2 eine Selektion von Teilen des Signals Sign.1 erfolgt.

Zu diesem Zweck werden die genannten Eingangssignale einem Übertrager Ü zugeführt und dort jeweils unter Verwendung einer Leiterschleife in die Nähe jeweils eines magnetosensitiven Detektors 1 bzw. 3 gebracht. Diese Detektoren sind Bestandteil einer zwischen einem Versorgungspannungsanschluß Vₛₛ und Masse vorgesehenen Parallelschaltung mit zwei Pfaden. Im ersten Pfad sind magnetosensitive Detektoren 1 und 2 in Form einer Reihenschaltung angeordnet. Der zweite Pfad enthält magnetosensitive Detektoren 3 und 4, die ebenfalls eine Reihenschaltung bilden. Vom Verbindungspunkt 12 zwischen den magnetosensitiven Detektoren 1 und 2 führt eine Signalverbindung zu einem Eingang eines ersten Differenzverstärkers 5. Dessen anderer Eingang ist mit dem Verbindungspunkt 13 zwischen den beiden magnetosensitiven Detektoren 3 und 4 verbunden.

An den Ausgang des ersten Differenzverstärkers 5 ist ein weiterer Differenzverstärker 14 angeschlossen. Dem weiteren Eingang dieses Differenzverstärkers 14 ist eine von einem Referenzspannungseingang 15 abgeleitete Referenzspannung U_{ref} zugeführt.

Am Ausgang 16 des Differenzverstärkers 14 ist ein Ergebnissignal OUT abgreifbar, das mittels des Signals Sign.2 selektierten Abschnitten des Signals Sign.1 entspricht. Dieses Ergebnissignal OUT steht potentialgetrennt von den genannten Eingangssignalen zur Verfügung.

Unterhalb des in der Figur 2 dargestellten Blockschaltbildes sind Signalverläufe vom im Blockschaltbild auftretenden Signalen gezeigt. Bei den miteinander zu verknüpfenden Signalen Sign.1 und Sign.2 handelt es sich jeweils um Rechtecksignale. Mit Uₒᵤₜ ist die zwischen den Schaltungspunkten 12 und 13 anliegende Spannung bezeichnet, die der zwischen den beiden Eingängen des ersten Differenzverstärkers 5 vorliegenden Spannung entspricht. U_{ref} ist die am Eingang 15 anliegende Referenzspannung. Mit OUT ist das am Ausgang 16 abgreifbare Ergebnissignal bezeichnet, welches potentialgetrennt von den Eingangssignalen zur Verfügung steht.

Bei diesem Ausführungsbeispiel wird folglich eine galvanische magnetosensitive Potentialtrennung mit Freigabe von Teilen des Eingangssignals Sign.1 durch das Eingangssignal Sign.2 erreicht.

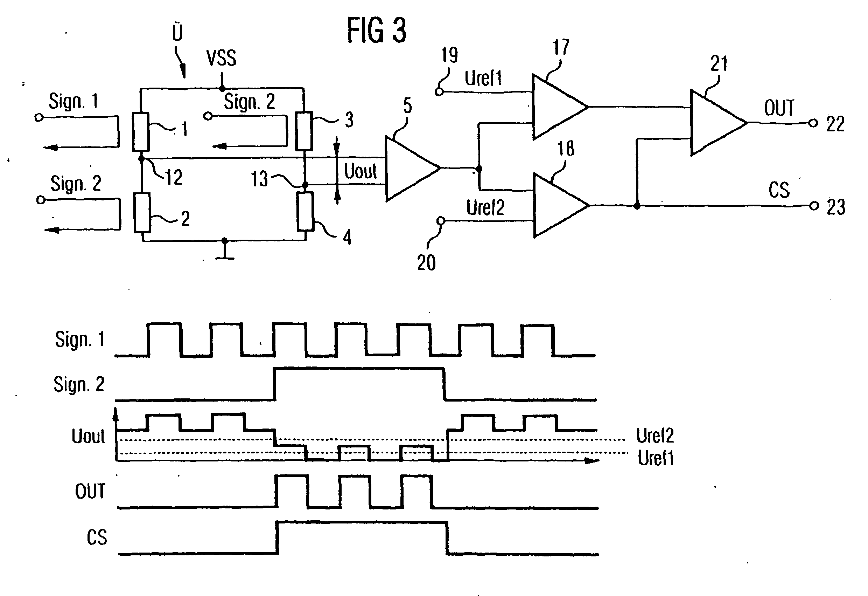

Die Figur 3 zeigt ein drittes Ausführungsbeispiel für die Erfindung. Gemäß diesem Ausführungsbeispiel werden der gezeigten Schaltung auf einer ersten Signalleitung ein Eingangssignal Sign.1, auf einer zweiten Signalleitung ein Eingangssignal Sign.2 und auf einer dritten Signalleitung ebenfalls das Eingangssignal Sign.2 zugeführt. Diese Eingangssignale sollen derart miteinander verknüpft werden, daß mittels des Signals Sign.2 Teile des Signals Sign.1 selektiert und weiterhin ein Chipselect-Signal erzeugt wird.

Zu diesem Zweck werden die genannten Eingangssignale einem Übertrager Ü zugeführt und dort unter Verwendung jeweils einer Leiterschleife in die Nähe jeweils eines magnetosensitiven Detektors 1, 2 bzw. 3 gebracht Diese Detektoren sind Bestandteil einer zwischen einem Versorgungsspannungsanschluß Vₛₛ und Masse vorgesehenen Parallelschaltung mit zwei Pfaden. Im ersten Pfad sind magnetosensitive Detektoren 1 und 2 in Form einer Reihenschaltung angeordnet. Der zweite Pfad enthält magnetosensitive Detektoren 3 und 4, die ebenfalls eine Reihenschaltung bilden. Vom Verbindungspunkt 12 zwischen den magnetosensitiven Detektoren 1 und 2 führt eine Signalverbindung zu einem Eingang eines ersten Differenzverstärkers 5. Dessen anderer Eingang ist mit dem Verbindungspunkt 13 zwischen den beiden magnetosensitiven Detektoren 3 und 4 verbunden.

An den Ausgang des ersten Differenzverstärkers 5 sind zwei weitere, parallel zueinander angeordnete Differenzverstärker 17 und 18 angeschlossen. Dem weiteren Eingang des Differenzverstärkers 17 ist eine von einem Referenzspannungseingang 19 abgeleitete Referenzspannung U_{ref1} zugeführt. Der weitere Eingang des Differenzverstärkers 18 ist mit einem Eingang 20 verbunden, an welchem eine Referenzspannung U_{ref2} anliegt.

Der Ausgang des Differenzverstärkers 17 ist mit einem Eingang eines weiteren Differenzverstärkers 21 verbunden. Dem anderen Eingang des Differenzverstärkers 21 wird das Ausgangssignal des Differenzverstärkers 18 zugeführt.

Das Ausgangssignal des Differenzverstärkers 21 wird als Ergebnissignal OUT am Ausgang 22 zur Verfügung gestellt und entspricht einem mittels des Eingangssignals Sign.2 selektierten Anteil des Eingangssignals Sign.1. Das Ergebnissignal OUT steht potentialgetrennt von den genannten Eingangssignalen zur Verfügung.

Das Ausgangssignal des Differenzverstärkers 18 wird einem Ausgangsanschluß 23 zugeführt und entspricht dem gewünschten Chipselect-Signal CS. Auch dieses steht am Ausgang 23 potentialgetrennt von den Eingangssignalen zur Verfügung.

Unterhalb des in Figur 3 dargestellten Blockschaltbildes sind Signalverläufe von im Blockschaltbild auftretenden Signalen gezeigt. Die oberen beiden Signalverläufe entsprechen den Eingangssignalen Sign.1 und Sign.2. Das zwischen den Eingängen des ersten Differenzverstärkers 5 anliegende Signal Uₒᵤₜ ist ebenso wie die Referenzspannungen U_{ref1} und U_{ref2} in der mittleren Darstellung angegeben. Die an den Ausgängen 22 und 23 zur Verfügung gestellten Ergebnissignale OUT und CS sind den beiden unteren Darstellungen entnehmbar.

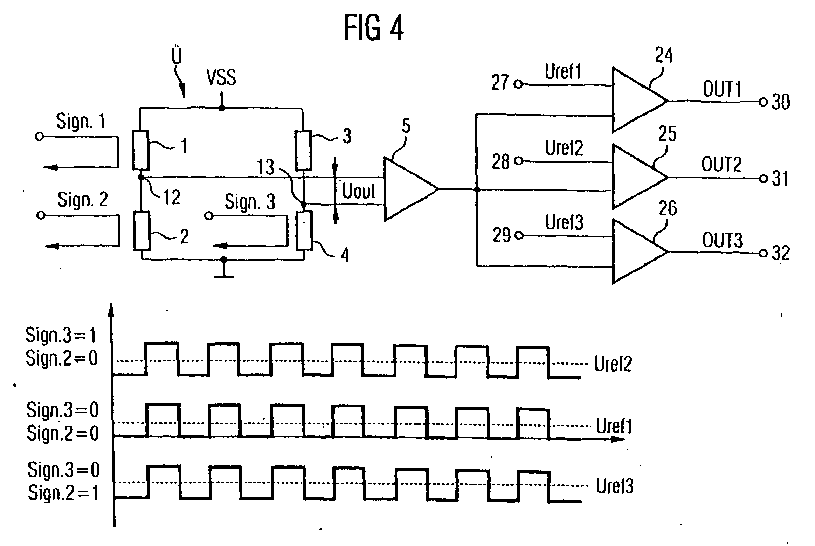

Die Figur 4 zeigt ein viertes Ausführungsbeispiel für die Erfindung. Gemäß diesem Ausführungsbeispiel sollen die drei der gezeigten Schaltung zugeführten Eingangssignale Sign.1, Sign.2 und Sign.3 im Sinne einer potentialgetrennten Kanalumschaltung logisch miteinander verknüpft werden, so daß ausgangsseitig Signale zur Verfügung gestellt werden, die entweder in einem Kanal 1 oder in einem Kanal 2 oder in einem Kanal 3 gelegen sind.

Zu diesem Zweck werden die genannten Eingangssignale einem Übertrager Ü zugeführt und dort unter Verwendung jeweils einer Leiterschleife in die Nähe jeweils eines magnetosensitiven Detektors 1, 2 bzw. 4 gebracht. Diese Detektoren sind Bestandteil einer zwischen einem Versorgungsspannungsanschluß Vₛₛ und Masse vorgesehenen Parallelschaltung mit zwei Pfaden. Im ersten Pfad sind magnetosensitive Detektoren 1 und 2 in Form einer Reihenschaltung angeordnet. Der zweite Pfad enthält magnetosensitive Detektoren 3 und 4, die ebenfalls eine Reihenschaltung bilden. Vom Verbindungspunkt 12 zwischen den magnetosensitiven Detektoren 1 und 2 führt eine Signalverbindung zu einem Eingang eines ersten Differenzverstärkers 5. Dessen anderer Eingang ist mit dem Verbindungspunkt 13 zwischen den beiden magnetosensitiven Detektoren 3 und 4 verbunden.

An den Ausgang des ersten Differenzverstärkers 5 sind drei weitere, parallel zueinander angeordnete Differenzverstärker 24, 25 und 26 angeschlossen. Dem weiteren Eingang des Differenzverstärkers 24 ist eine von einem Referenzspannungseingang 27 abgeleitete Referenzspannung U_{ref1} zugeführt. Der weitere Eingang des Differenzverstärkers 25 ist mit einem Eingang 28 verbunden, an welchem eine Referenzspannung U_{ref2} anliegt. Dem weiteren Eingang des Differenzverstärkers 26 ist eine von einem Referenzspannungseingang 29 abgeleitete Referenzspannung U_{ref3} zugeführt.

Am Ausgang 30 des Differenzverstärker 24 ist ein Ergebnissignal OUT1, am Ausgang des Differenzverstärkers 25 ein Ergebnissignal OUT2 und am Ausgang des Differenzverstärkers 26 ein Ergebnissignal OUT3 abgreifbar. Das Ergebnissignal OUT1 entspricht den Signalen im Kanal 1, das Ergebnissignal OUT2 den Signalen im Kanal 2 und das Ergebnissignal OUT3 den Signalen im Kanal 3, wobei diese Signale jeweils potentialgetrennt von den Eingangssignalen Sign.1, Sign.2 und Sign.3 vorliegen.

Unterhalb des in der Figur 4 dargestellten Blockschaltbildes sind Signalverläufe von im Blockschaltbild auftretenden Signalen aufgezeigt. Aus dem oberen Signalverlauf ist ersichtlich, daß für Sign.2 = 0 und Sign.3 = 1 das Ausgangssignal OUT2 im Kanal 2 am Ausgang 31 zur Verfügung gestellt wird, daß für Sig.2 = 0 und Sign.3 = 0 das Ausgangssignal OUT1 im Kanal 1 am Ausgang 30 zur Verfügung gestellt wird und daß für Sign.2 = 1 und Sign.3 = 0 das Ausgangssignal OUT3 im Kanal 3 am Ausgang 32 zur Verfügung gestellt wird. Dabei entsprechen die genannten Ausgangssignale jeweils dem potentialgetrennten Eingangssignal Sign.1, welches durch die Wahl vorbestimmter Werte von Sign.2 und Sign.3 an den jeweiligen Kanal weitergeleitet wird.

Aus den obigen Ausführungsbeispielen geht hervor, daß durch eine von der jeweils gewünschten Signalverknüpfung abhängige Ansteuerung und Verschaltung von magnetosensitiven Elementen, beispielsweise giant magnetic resistance-Brücken (GMR) und einer geeigneten Auswerteschaltung logische Verknüpfungen realisiert werden können, wobei die jeweiligen Ausgangssignale potentialgetrennt zur Verfügung stehen. Diese Verknüpfungen können stets dann mit geringem Aufwand realisiert werden, wenn ohnehin in der vorliegenden Schaltung artgleiche Technologien verwendet werden.

## Patentansprüche

1. Verfahren zur logischen Verknüpfung von Signalen mit folgenden Verfahrensschritten:
a) die miteinander zu verknüpfenden Signale werden auf getrennten Signalleitungen einem magnetosensitive Koppelelemente aufweisenden Übertrager zugeführt;
b) die miteinander zu verknüpfenden Signale werden im Übertrager jeweils potentialfrei übertragen und von einem magnetosensitiven Detektor des jeweiligen Koppelelementes detektiert;
c) die von den magnetosensitiven Detektoren der Koppelelemente abgeleiteten Signale werden einer Auswerteeinheit zugeführt und dort ausgewertet;
d) an dem Ausgang oder den Ausgängen der Auswerteeinheit werden Ergebnissignale zur Verfügung gestellt.

2. Verfahren nach Anspruch 1, **dadurch gekennzeichnet, daß** von den magnetosensitiven Detektoren der Koppelelemente abgeleitete Signale den Eingängen eines ersten Differenzverstärkers zugeführt werden und die Ermittlung der Ergebnissignale durch Auswertung des Ausgangssignals des ersten Differenzverstärkers unter Verwendung mindestens eines an den Ausgang des ersten Differenzverstärkers angeschlossenen weiteren Differenzverstärkers erfolgt.

3. Verfahren nach Anspruch 2, **dadurch gekennzeichnet, daß** dem weiteren Differenzverstärker neben dem Ausgangssignal des ersten Differenzverstärkers ein Referenzspannungssignal zugeführt wird.

4. Vorrichtung zur logischen Verknüpfung von Signalen, **dadurch gekennzeichnet, daß** sie einen mindestens zwei magnetosensitive Koppelelemente aufweisenden Übertrager (Ü) aufweist;
die Koppelelemente eingangsseitig eine Leiterschleife und ausgangsseitig einen magnetosensitiven Detektor (1,2,3,4) aufweisen,
die Koppelelemente einen Eingang für eines der zu verknüpfenden Signale aufweisen,
an die Ausgänge der magnetosensitiven Detektoren eine Auswerteeinheit (5-9; 5,14,15; 5,17-21; 5,24-29) angeschlossen ist, und
die Auswerteeinheit einen oder mehrere Ausgangsanschlüsse (10,11; 16; 22,23; 30-32) aufweist, an denen Ergebnissignale abgreifbar sind.

5. Vorrichtung nach Anspruch 4, **dadurch gekennzeichnet, daß** der Übertrager (Ü) ausgangsseitig eine Parallelschaltung zweier jeweils in Reihe geschalteter magnetosensitiver Detektoren (1,2,3,4) aufweist, daß jeweils vom Verbindungspunkt (12,13) zwischen den beiden in Reihe geschalteten magnetosensitiven Detektoren eine Signalleitung an einen Eingangsanschluß eines ersten Differenzvertärkers (5) geführt ist, und daß der Ausgang des ersten Differenzverstärkers (5) mit einem ersten Eingang eines weiteren Differenzverstärkers verbunden ist, dessen zweiter Eingang an eine Referenzspannungsquelle angeschlossen ist.

6. Vorrichtung nach Anspruch 5, **dadurch gekennzeichnet, daß** an den Ausgang des ersten Differenzverstärkers eine Parallelschaltung mehrerer weiterer Differenzverstärker (8,9; 17,18; 24-26) angeschlossen ist, deren jeweiliger zweiter Eingang jeweils an eine Referenzspannungsquelle angeschlossen ist.

## Claims

1. Method for logically combining signals, comprising the following steps:
a) the signals to be combined with one another are fed on separate signal lines to a transformer incorporating magnetosensitive coupling elements;
b) the signals to be combined together are transmitted in the transformer in an electrically floating manner in each case and are detected by a magnetosensitive detector of the respective coupling element;
c) the signals derived from the magnetosensitive detectors of the coupling elements are fed to an evaluating unit where they are evaluated;
d) result signals are provided at the output or outputs of the evaluating unit.

2. Method according to claim 1,
**characterised in that** signals derived from the magnetosensitive detectors of the coupling elements are fed to a first differential amplifier and the result signals are determined by evaluation of the output signal of the first differential amplifier using at least one other differential amplifier connected to the output of the first differential amplifier.

3. Method according to claim 2,
**characterised in that** a reference voltage signal is fed to the other differential amplifier in addition to the output signal of the first differential amplifier.

4. Device for logically combining signals,
**characterised in that** it comprises a transformer (Ü) comprising at least two magnetosensitive coupling elements;
the coupling elements have a conductor loop on the input side and a magnetosensitive detector (1,2,3,4) on the output side,
the coupling elements have an input for one of the signals to be combined,
a evaluating unit (5-9; 5,14,15; 5,17-21; 5,24-29) is connected to the outputs of the magnetosensitive detectors, and
the evaluating unit has one or more output terminals (10,11; 16; 22,23; 30-32) at which the result signals can be tapped off.

5. Device according to claim 4,
**characterised in that** the transformer (Ü) has on the output side a parallel arrangement of two series-connected magnetosensitive detectors (1,2,3,4), that a signal line is routed in each case to an input terminal of the first differential amplifier (5) from the connection point (12,13) between the two series-connected magnetosensitive detectors, and that the output of the first differential amplifier (5) is connected to a first input of another differential amplifier whose second input is connected to a reference voltage source.

6. Method according to claim 5,
**characterised in that** a parallel arrangement of a plurality of other differential amplifiers (8,9; 17,18; 24-26), whose second input is connected to a reference voltage source in each case, is connected to the output of the first differential amplifier.

## Revendications

1. Procédé de combinaison logique de signaux, comprenant les étapes suivantes :
a) les signaux à combiner entre eux sont envoyés sur des lignes de signal séparées à un transformateur comportant des éléments de couplage magnétosensibles ;
b) les signaux à combiner entre eux sont transmis dans le transformateur à chaque fois sans potentiel et sont détectés par un détecteur magnétosensible de l'élément de couplage respectif ;
c) les signaux dérivés des détecteurs magnétosensibles des éléments de couplage sont envoyés à une unité d'évaluation où ils sont évalués ;
d) des signaux de résultat sont mis à disposition à la sortie ou aux sorties de l'unité d'évaluation.

2. Procédé selon la revendication 1, **caractérisé par le fait que** des signaux dérivés des détecteurs magnétosensibles des éléments de couplage sont envoyés aux entrées d'un premier amplificateur différentiel et que la détermination des signaux de résultat s'effectue en évaluant le signal de sortie du premier amplificateur différentiel en utilisant au moins un autre amplificateur différentiel raccordé à la sortie du premier amplificateur différentiel.

3. Procédé selon la revendication 2, **caractérisé par le fait que**, outre le signal de sortie du premier amplificateur différentiel, un signal de tension de référence est envoyé à l'autre amplificateur différentiel.

4. Dispositif de combinaison logique de signaux, **caractérisé par le fait qu'**il comporte un transformateur (Ü) comportant au moins deux éléments de couplage magnétosensibles ;
les éléments de couplage comportent côté entrée une boucle de conducteur et côté sortie un détecteur magnétosensible (1, 2, 3, 4) ;
les éléments de couplage comportent une entrée pour l'un des signaux à combiner ;
une unité d'évaluation (5 à 9 ; 5, 14, 15 ; 5, 17 à 21 ; 5, 24 à 29) est raccordée aux sorties des détecteurs magnétosensibles ; et
l'unité d'évaluation comporte une ou plusieurs bornes de sortie (10, 11 ; 16 ; 22, 23 ; 30, 32) auxquelles des signaux de résultat peuvent être prélevés.

5. Dispositif selon la revendication 4, **caractérisé par le fait que** le transformateur (Ü) comporte côté sortie un circuit parallèle composé de deux détecteurs magnétosensibles (1, 2, 3, 4) branchés à chaque fois en série, qu'une ligne de signal est conduite à chaque fois du point de jonction (12, 13) entre les deux détecteurs magnétosensibles branchés en série à une borne d'entrée d'un premier amplificateur différentiel (5) et que la sortie du premier amplificateur différentiel (5) est reliée à une première entrée d'un autre amplificateur différentiel dont la deuxième entrée est raccordée à une source de tension de référence.

6. Dispositif selon la revendication 5, **caractérisé par le fait qu'**un circuit parallèle composé de plusieurs autres amplificateurs différentiels (8, 9 ; 17, 18 ; 24 à 26) dont la deuxième entrée respective est raccordée à chaque fois à une source de tension de référence est raccordé à la sortie du premier amplificateur différentiel.
